## Europäisches Patentamt
## European Patent Office
## Office européen des brevets

(19)

(11) Publication number: **0 127 682**

A1

(12)

# EUROPEAN PATENT APPLICATION

published in accordance with Art. 158(3) EPC

(21) Application number: **82902094.0**

(22) Date of filing: **13.07.82**

Data of the international application taken as a basis:

(86) International application number:
**PCT/JP82/00264**

(87) International publication number:
**WO84/00464 (02.02.84 84/03)**

(51) Int. Cl.³: **H 05 K 3/34**
**C 09 J 3/14**
**//C08F299/00**

---

(43) Date of publication of application:
**12.12.84 Bulletin 84/50**

(84) Designated Contracting States:
**DE GB**

(71) Applicant: **Matsushita Electric Industrial Co., Ltd.**
**1006, Oaza Kadoma**
**Kadoma-shi Osaka-fu, 571(JP)**

(72) Inventor: **HOHCHIN, Ryuzoh**
**107, Touda-cho 4-chome Moriguchi-shi**
**Osaka-fu 570(JP)**

(72) Inventor: **KUDOH, Shinichi**
**14-1-126, Kunimatsu-cho Neyagawa-shi**
**Osaka-fu 572(JP)**

(72) Inventor: **MAEDA, Yukio**
**44-30, Himurodai 1-chome Hirakata-shi**
**Osaka-fu 573-01(JP)**

(74) Representative: **Crawford, Andrew Birkby et al,**
**A.A. THORNTON & CO. Northumberland House 303-306**
**High Holborn**
**London WC1V 7LE(GB)**

---

(54) **METHOD OF MOUNTING ELECTRONIC PART.**

(57) Method of mounting an electronic part, which comprises the steps of coating a two-liquid adhesive (12) composed of a main agent and a separate curing accelerator using a dispenser containing a mixture (2) of the main agent and the curing accelerator on the area of a printed circuit board (10) where the part is to be placed, placing the electronic part (3) on the area coated with the adhesive (12), thereafter heating or shining ultra-violet light thereon to cure the adhesive (12), thereby temporarily securing the part (13), and then soldering the part on. This enables the mounting of large-sized electronic parts.

Fig. 3

SPECIFICATION

Title of the Invention

Method of Fitting Electronic Parts

Technical Field

The present invention relates to a method of fitting electronic parts on printed wiring boards by using an adhesive.

Background Art

Recently, along with miniaturization of electronic equipments, the method of fitting electronic parts on printed wiring boards in which they are soldered onto the board, after securing them thereon by use of a thermosetting adhesive or an ultraviolet ray setting adhesive, etc., without inserting lead terminals in the printed wiring board, has become often employed. Formerly, electronic parts which were fixed on a substrate without inserting lead wires were mostly limited to small parts such as chip resistances, laminated ceramic condensers or minimold transistors, but recently, such large parts as power IC, flat package IC, DIP type IC, etc., have come into use. Use of such large parts involved a problem that because of the large thermal capacities of these electronic parts, the temperature of the adhesive was hard to rise and, consequently, the adhesive failed to set. For setting an adhesive, increasing the setting time or raising the setting temperature is necessary, but in that way, such inadequacies as oxidation of copper foils, warping of the printed wiring board causing soldering failure and, further, degradation of characteristics of electronic parts due to long duration of heating were encountered. Long setting time involves such inconveniences as requiring long production processes, wide spaces and larger amount of power.

As adhesives which set at relatively low temperatures, epoxy or acryl base two liquid component adhesives are available on the market. Many of them set several minutes after mixing their main component and setting agent, thus their usable periods after the mixing are too short for their proper handling. For this reason, automation of the process of applying such an adhesive on a printed wiring board by means of a dispenser is very difficult.

Disclosure of the Invention

The present invention provides a means for overcoming such difficulties and thus a fitting method of electronic parts for securing large units on a substrate without inserting lead terminals.

Thus the present invention provides a method comprising applying a two liquid component adhesive on the portion of a printed wiring board on which the parts is to be mounted from an appropriate adhesive mixing and applying means, for example, a two liquid components dispenser with a mixer, subsequently, placing the electronic parts on this adhesive, then, tentatively fixing the aforementioned electronic parts by setting the aforementioned adhesive by way of heating or irradiating ultraviolet rays, followed by soldering this printed wiring board. Because the setting can be made at a lower temperature by using the two liquid component adhesive, as compared with single liquid component adhesives, this method is suitable for bonding such large parts as power IC, flat package IC, DIP type IC, etc., onto printed wiring boards.

In the following, the adhesive employed in exercising this invention is described: The too liquid component adhesive consists of its main component and a setting promoter, both are acrylic resin compounds. The main component is composed of 100 weight parts of a composite resin material consisting of acrylic oligomers and low viscosity acrylates or methacrylates, 0.1 ∿ 10 weight parts of a thermal polymerization initiator and 20 ∿ 150 weight parts of an inorganic filler, with some coloring agent, polymerization inhibitor and agent for providing thixotropic property, etc., mixed therewith, as required. As the acrylic oligomers, there are available bisphenol A epoxy acrylate, cresol novolak epoxyacrylate, phenol novolak epoxyacrylate, urethane acrylate bisphenol A tetraethylene glycol diacrylate, etc. As the low viscosity acrylates which are available include acrylic acid alkylesters, trimethylol propane triacrylate, diethylene glycol diacrylate, tetraethylene glycol diacrylate, etc. As the low viscosity methacrylates, methacryl acid alkylester, glycidyl methacrylate , 2-hydroxy methacrylate, etc., are available.

As the thermal polymerization initiators used include organic peroxides such as benzoyl peroxide, t-butyl peroxy benzoate and cumene hydroperoxide, etc., and azo compounds such as azo-bis-isobutyronitryl, etc.

As the inorganic filler, silica powder, talc, potassium carbonate, alumina powder and magnesium hydroxide, etc., are used.

The setting promoter is composed of 100 weight parts of an acrylic resin composite material of exactly the same composition as that of the main component, 0.1 ∿ 20 weight parts of a polymerization promoter and 20 ∿ 170 weight parts of an inorganic filler, with some coloring agent, polymerization inhibitor and agent for providing the thixotropic property further mixed in, as required.

When setting the adhesive by joint application of irradiation of ultraviolet rays and heating, it is desirable to mix a photo-sensitizer into either the main component or the setting promoter or both.  As such a photo-sensitizer, benzoin alkylether, *benzil methyl ketal* , 2,2-diethoxy acetophenone, etc., are employed.

As the light source for the irradiation of ultraviolet rays, high pressure mercury lamps, ultrahigh pressure mercury lamps, metal halide lamps and xenon lamps, etc., are available.

Brief Description of the Drawings

FIG. 1 is a front view of an adhesive dispenser showing an embodiment of this invention;

FIG. 2 is an enlarged sectional view of the essential part of the same;

FIG. 3 is a sectional view of an printed wiring board showing how the electronic unit is mounted; and

FIG. 4 is a schematic sketch of the setting furnace.

The Most Preferable Mode for Exercising the Invention

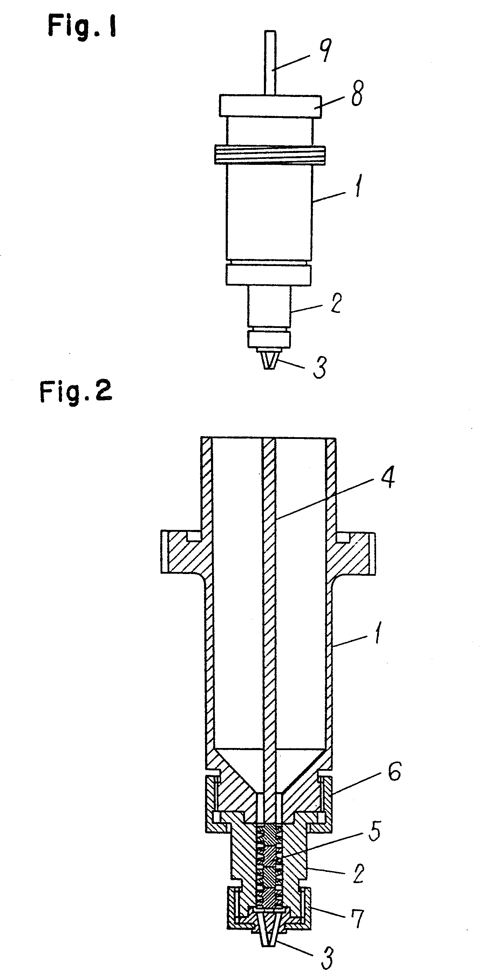

In the following, an embodiment of this invention is described with reference to FIGS. 1 ∿ 4.  Numeral 1 designates tank section.  The two liquid components mixer/ dispenser comprises the tank section 1, mixer section 2 for mixing the main component and the setting promoter and discharge nozzle section 3 and a partition 4 is provided in the tank section 1 to have a structure such that the main component and the setting agent could not mix together. Inside the mixer section 2, several mixing elements 5 are inserted and the mixer section 2 is attached to the tank section 1 by means of a set screw ring 6 and the nozzle section 3 is, in turn, coupled to the tip of the mixer section also by means of a set screw ring 7.

Besides, on the top of the tank, there are provided a cover 8 and a hose 9 for supplying the pressurizing air. The main component and the setting promoter are divided in the tank section 1 by the partition 4. The main component and the setting promoter are pressurized by air, mixed with each other while passing through the mixing elements 5 inside the mixer section 2 and, then, discharged through the discharge nozzle section 3. The discharge of the adhesive should desirably performed at an air pressure of 1 ∿ 5 kg/cm$^2$.

In the following, an embodiment of the adhesive used with the two liquid components mixer/dispenser is described.

(Example)

Used as the main component was a resin composite material consisting of 100 weight parts of acrylates including 20 parts of cresol novolak epoxy acrylate, 35 weight parts of urethane acrylate, 15 weight parts of 2-hydroxy ethyl methacrylate, 5 weight parts of trimethylol propane triacrylate and 15 weight parts of *glycidyl methacrylate*

and 3 weight parts of t-butyl peroxy benzoate, 1 weight part of benzyl dimethyl ketal, 1 weight part of Carmine 6B, 30 weight parts of talc, 50 weight parts of fused silica powder and 0.02 weight parts of parabenzoquinone.

Used as the setting promoter was a resin composite material consisting of 100 weight parts of acrylates of exactly the same composition as that of the aforementioned main component, thus including 20 weight parts of bis-phenol A epoxy acrylate, 10 weight parts of cresol novolak epoxy acrylate, 35 weight parts of urethane acrylate, 15 weight parts of 2-hydroxyethyl methacrylate, 5 weight parts of trimethylol propane triacylate and 15 weight parts of

*glycidyl methacrylate* , compounded with 16 weight parts of a 6% methanol solution of cobalt naphthenate, 3 weight parts of titanium dioxide, 35 weight parts of talc and 50 weight parts of fused silica powder.  The main component has a characteristic of being set by irradiation of ultra- violet rays or by heating, it may be set in approximately 15 sec at 150°C, for example.  The main component and the setting promoter should desirably be mixed at a weight ratio of about 1 : 1.  If the main component is too much, the setting property will degrade, but if the setting pro- motoer is used in excess, the electric insulating property will decline and the setting property also get worse a little.  Because the mixture of the main component and the setting promoter has a usable duration of about 12 hours after being mixed, its handling is easy and adaptable for automation of production process.

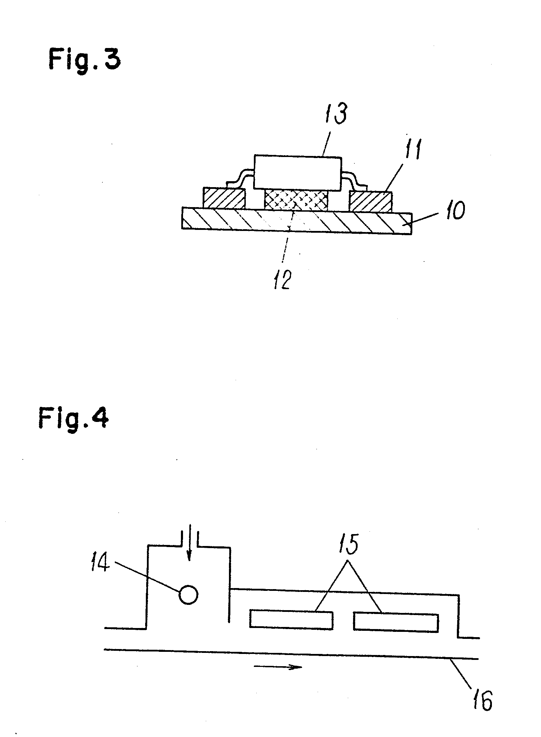

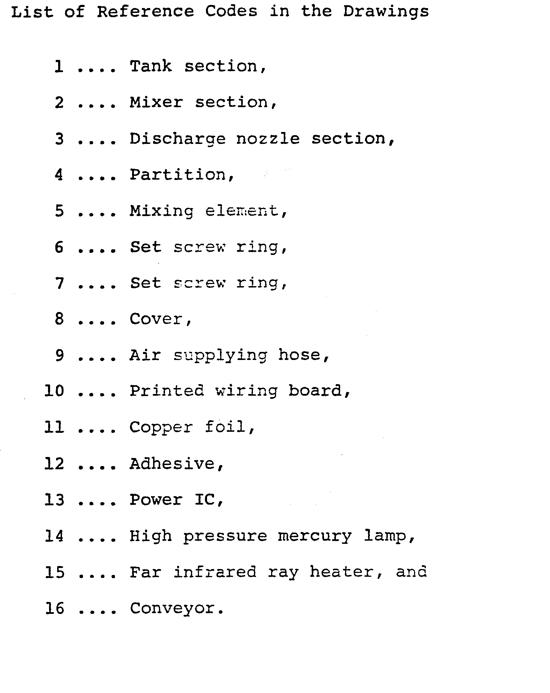

In fitting and soldering an electronic parts, after applying the adhesive 12 on a printed substrate and mounting a power IC 13, the adhesive was set by passing this assembly at a conveyor speed of 10 m/min through a 12 m long setting furnace shown in FIG. 4 composed of a high pressure mercury lamp 14, far infrared ray heater 15 and conveyor 16 and, thereafter, dipping it in solder.  No such problem as fall of power IC nor  any shift took place, showing faborable sholdered state.  The setting furnace was operated with its temperature so set that the surface temperature of the printed substrate was maintained below approximately 155°C at the maximum for about 30 seconds, when it is passed through the setting furnace.

(Comparison Example)

The main component above-described in the Example is an adhesive which singly is settable by joint application of ultraviolet rays and heat.  This main component was singly applied on similar printed wiring boards as those of the Example, a chip resistance, laminated ceramic condenser and power IC were, repectively, bonded thereon and

0127682

the adhesive was set under the same condition and in the
same setting furnace as in the case of the Example.  Result:
With the chip resistance and the laminated ceramic condenser, an adhesive strength of approximately 4 kg was
achieved; the adhesive was found well set.  In contrast,
the adhesive with the power IC was found still unset.

Industrial Applicability

As described in the foregoing, the present invention
is characterized by its capability of bonding such large
parts as power IC, flat  package IC, etc., on printed
wiring boards and setting this adhesive in short time and
at a relatively low temperature and achieves prominent
effects of improved soldering property and lessened
degradation in characteristics of electronic parts because
of diminished warping of the printed wiring board and
decreased oxidation of copper foils.

What is claimed is:

1. A method of fitting an electronic parts comprising applying a two liquid component adhesive consisting of its main component and a setting promoter on the parts mounting portion on a printed wiring board from a dispenser having a mixing part for mixing the main component and the setting promoter of the adhesive which are separated beforehand, then, mounting the electronic parts on the portion coated with the adhesive and, thereafter, fixing the aforementioned electronic parts by setting the aforementioned adhesive by way of heating or irradiation of ultraviolet rays, followed by soldering.

2. A method of fitting an electronic parts according to Claim 1, wherein the main component of the aforementioned two liquid component adhesive is composed of 100 weight parts of resin composite material consisting of acrylic oligomers and low viscosity acrylates or metacrylates, 0.1 ∿ 10 weight parts of thermal polymerization initiator and 20 ∿ 150 weight parts of inorganic filler and the setting promoter of the aforementioned two liquid component adhesive is composed of 100 weight parts of the acrylic resin composite material of exactly the same composition as that of the aforementioned main component, 0.1 ∿ 20 weight parts of polymerization promoter and 20 ∿ 170 weight parts of

inorganic filler.

**Fig. 1**

**Fig. 2**

Fig.3

Fig.4

0127682

List of Reference Codes in the Drawings

    1 .... Tank section,

    2 .... Mixer section,

    3 .... Discharge nozzle section,

    4 .... Partition,

    5 .... Mixing element,

    6 .... Set screw ring,

    7 .... Set screw ring,

    8 .... Cover,

    9 .... Air supplying hose,

10 .... Printed wiring board,

11 .... Copper foil,

12 .... Adhesive,

13 .... Power IC,

14 .... High pressure mercury lamp,

15 .... Far infrared ray heater, and

16 .... Conveyor.

# INTERNATIONAL SEARCH REPORT

0127682

International Application No. PCT/JP82/00264

## I. CLASSIFICATION OF SUBJECT MATTER (if several classification symbols apply, indicate all) ³

According to International Patent Classification (IPC) or to both National Classification and IPC

Int. Cl.³ H05K3/34, C09J3/14 // C08F299/00

## II. FIELDS SEARCHED

### Minimum Documentation Searched ⁴

| Classification System | Classification Symbols |
|---|---|
| I P C | H05K3/34, C09J 3/14, C08F 299/00 |

| | Documentation Searched other than Minimum Documentation to the Extent that such Documents are Included in the Fields Searched ⁵ |
|---|---|
| | Jitsuyo Shinan Koho          1951 – 1982 |
| | Kokai Jitsuyo Shinan Koho    1971 – 1982 |

## III. DOCUMENTS CONSIDERED TO BE RELEVANT ¹⁴

| Category* | Citation of Document, ¹⁶ with indication, where appropriate, of the relevant passages ¹⁷ | Relevant to Claim No. ¹⁸ |
|---|---|---|
| A | JP,A, 56-85896 (Pionner Electronic Corp.) 13. July. 1981 (13.07.81) | 1, 2 |
| A | JP,A, 57-16083 (Hitachi, Ltd.) 27. January. 1982 (27.01.82) | 2 |

* Special categories of cited documents: ¹⁵

"A" document defining the general state of the art which is not considered to be of particular relevance

"E" earlier document but published on or after the international filing date

"L" document which may throw doubts on priority claim(s) or which is cited to establish the publication date of another citation or other special reason (as specified)

"O" document referring to an oral disclosure, use, exhibition or other means

"P" document published prior to the international filing date but later than the priority date claimed

"T" later document published after the international filing date or priority date and not in conflict with the application but cited to understand the principle or theory underlying the invention

"X" document of particular relevance; the claimed invention cannot be considered novel or cannot be considered to involve an inventive step

"Y" document of particular relevance; the claimed invention cannot be considered to involve an inventive step when the document is combined with one or more other such documents, such combination being obvious to a person skilled in the art

"&" document member of the same patent family

## IV. CERTIFICATION

| Date of the Actual Completion of the International Search ² | Date of Mailing of this International Search Report ² |
|---|---|
| September 28, 1982 (28.09.82) | October 12, 1982 (12.10.82) |

| International Searching Authority ¹ | Signature of Authorized Officer ²⁰ |
|---|---|
| Japanese Patent Office | |